Europäisches Patentamt

European Patent Office

Office européen des brevets

(11) Publication number: **0 232 972 B1**

# EUROPEAN PATENT SPECIFICATION

(45) Date of publication of patent specification: **08.09.93**  (51) Int. Cl.5: **G03F 7/038**

(21) Application number: **87300219.0**

(22) Date of filing: **12.01.87**

(54) **Negative photoresist compositions and processes for preparing thermally stable, negative images using them.**

(30) Priority: **13.01.86 US 818430**

(43) Date of publication of application:
**19.08.87 Bulletin 87/34**

(45) Publication of the grant of the patent:
**08.09.93 Bulletin 93/36**

(84) Designated Contracting States:
**AT BE CH DE FR GB IT LI LU NL SE**

(56) References cited:
EP-A- 0 132 867
EP-A- 0 164 248
US-A- 3 988 152

**C.G. ROFFEY: "Photopolymerization of surface coatings", 1982, page 46, John Wiley & Sons Ltd, London, GB**

**CHEMICAL ABSTRACTS, vol. 101, no. 17, 22nd October 1984, page 235, no. 145860u, Columbus, Ohio, US; A.V. KARYAKIN: "Luminescence-photochemical determination of chloroaromatic substances and pesticides in water" & ZH. ANAL. KHIM. 1984, 39(8), 1518-20**

(73) Proprietor: **ROHM AND HAAS COMPANY
Independence Mall West
Philadelphia Pennsylvania 19105(US)**

(72) Inventor: **Feely, Wayne Edmund
1172 Lindsay Lane
Rydal Pennsylvania 19046(US)**

(74) Representative: **Angell, David Whilton et al
ROHM AND HAAS (UK) LTD. European Operations Patent Department Lennig House 2 Mason's Avenue
Croydon CR9 3NB (GB)**

CHEMICAL ABSTRACTS, vol. 96, no. 10, 8th March 1982, page 586, no. 77426h, Columbus, Ohio, US; H.C.A. VAN BEEK et al.: "Photochemical radical chain dechlorination of DDT in 2-propanol" & IND. ENG. CHEM. PROD. RES. DEV. 1982, 21(1), 123-5

CHEMICAL ABSTRACTS, vol. 85, no. 19, 8th November 1976, page 155, no. 138575c, Columbus, Ohio, US; H. STEINWANDTER: "Contributions to the conversion of HCH isomers by the action of uv light. I. Isomerization of lindane to alpha-HCH" & CHEMOSPHERE 1976, 5(4), 245-8

**Description**

This invention is concerned with negative photoresist compositions comprising acid-hardening resin systems and certain halogenated organic compounds which are extremely sensitive to short wavelength actinic radiation, and to their use in the preparation of thermally stable, negative images on substrate surfaces.

Negative-acting, liquid-type photoresist compositions based upon cyclized rubber and containing diazide sensitizers are well known and are commonly employed in lithographic applications to form printing plate images. Their commercial acceptance in microelectronic applications, such as for creating micrometer size images on silicon wafers has, however, been limited by a number of technical problems. These problems include: difficulties in obtaining high quality, pinhole-free, coatings of good uniformity and adhesion on substrate surfaces without the need for special surface preparation or other processing steps; inadequate thermal stability and resolution capability for the resulting images to be useful in many microelectronic applications; and especially their need for organic solvents for developing the negative image.

For example, conventional negative-acting photoresists employ rubbery thermoplastic polymers, such as polyisoprene and cyclized rubber, which require the use of organic solvents for development. When such negative resists are developed it has been found that the exposed thermoplastic material will swell in the organic solvent developer. The resolution of the images are thereby compromised and in some instances the images will become distorted and therefore unusable. Organic solvent developers are also undesirable for environmental, health and flammability reasons.

Workers in the microlithographic art have been seeking improved photoresists which are capable of high resolution, and are thermally stable and resistant to plasma etching conditions used in subsequent wafer processing. Resolution could be improved if photosensitive materials could be found that are sensitive to short wave radiation and are suitable for inclusion in photoresist compositions.

"DCOPA" is a copolymer containing glycidyl methacrylate and 2,3-dichloropropylmethacrylate. It has been reported to be useful as an x-ray sensitive photoresist material in "Recent Printing and Registration Results with X-Ray Lithography", B. Fay, L. Tai and D. Alexander, SPIE Vol. 537 (1985) pg. 57-68. DCOPA is a soft rubbery material which softens at low temperatures, of less than approximately 100 °C, and is insufficiently resistant to plasma etching conditions used in subsequent wafer processing. This plasma etch resistance problem is inherent in aliphatic polymeric materials.

Novolak-containing photoresist materials are substantially aromatic materials which exhibit good plasma etch resistance; however, they are not thermally stable nor are they sensitive to short wavelength radiation such as x-rays.

In our EP-A-0164248 there is described a dual-acting, positive or negative, photosensitive composition containing an acid-hardening resin system and a photoacid generator useful in the near ultraviolet radiation spectrum for preparing aqueously-developable, thermally stable images. These dual-acting photosensitive compositions result in images which are substantially more thermally stable than images formed by using conventional photoresist compositions such as those formed from novolak resins. The photoacid generators used in the dual-acting photosensitive compositions of our EP-A-0164248 are those which are sensitive to near ultraviolet radiation ("near UV") having wavelengths of from about 300 to about 500 nanometers and more particularly about 365 nanometers. These near UV photoacid generators, such as diazonaphthoquinones, yield weak carboxylic acids, such as indenecarboxylic acid, when the photosensitive composition is exposed to near UV radiation. Further, these photoacid generators are typically present in the photosensitive composition at a concentration of from about 10 to 30 weight percent based on the total solids content of the photosensitive composition. However, the carboxylic acid photoacid generators used in combination with the acid-hardening resin systems were not found to be sensitive to shorter wavelengths, such as deep ultraviolet radiation ("deep UV"), that is, UV radiation having wavelengths of from about 210 to about 300 nanometers and more particularly 254 nanometers.

Compounds which generate strong inorganic acids, such as hydrochloric acid upon exposure to near UV radiation, as disclosed in U.S. Patents Nos. 3,692,560; 3,697,274; 3,890,152; and 4,404,272, were found to be unsuitable for use with acid-hardening resins for aqueously developing both positive and negative, thermally stable images.

We have now surprisingly found that certain halogenated organic compounds are highly sensitive to short wavelength actinic radiation, and that these compounds are compatible with, and effective at low concentrations to catalyze the crosslinking of, acid-hardening resins such that the combination can be used in a photoresist composition to form highly resolved, thermally stable and aqueously-developable negative images on substrate surfaces.

3

According to the present invention there is provided a negative-acting, aqueous base developable, photoresist composition which comprises:

(a) acid-hardening resin system comprising (I) aminoplast resin and reactive hydrogen-containing compound, or (II) phenoplast resin and latent formaldehyde-generating compound; and

(b) halogenated, organic, photoacid generating compound which selectively absorbs actinic radiation having a wavelength in the range of about 299 nanometers or less and which is selected from:

1,1-bis [p-chlorophenyl]-2,2,2-trichloroethane;

1,1-bis [p-methoxyphenyl]-2,2,2-trichloroethane;

1,2,5,6,9,10-hexabromocyclododecane;

1,10-dibromodecane;

1,1-bis [p-chlorophenyl]-2,2-dichloroethane;

4,4'-dichloro-2-(trichloromethyl) benzhydrol or 1,1-bis [p-chlorophenyl]-2,2,2-trichloroethanol;

hexachlorodimethyl sulfone;

2-chloro-6- (trichloromethyl) pyridine;

0,0-diethyl-0- (3,5,6-trichloro-2-pyridyl) phosphorothioate;

1,2,3,4,5,6-hexachlorocyclohexane;

N (1,1-bis [p-chlorophenyl]-2,2,2-trichloroethyl) acetamide;

tris [2,3-dibromopropyl] isocyanurate;

tris [2,3-dichloropropyl] phosphate;

1,1-bis [p-chlorophenyl]-2,2-dichloroethylene;

and their isomers and homologs.

The invention also provides a process for preparing a negative, thermally stable image on a substrate surface, which comprises:

(a) depositing a photosensitive solution on a substrate surface, the photosensitive solution comprising:

(i) acid-hardening resin system comprising (I) aminoplast resin and reactive hydrogen-containing compound, or (II) phenoplast resin and latent formaldehyde-generating compound; and

(ii) halogenated, organic, photoacid generating compound which selectively absorbs actinic radiation having a wavelength in the range of about 299 nanometers or less and which is selected from:

1,1-bis [p-chlorophenyl]-2,2,2-trichloroethane;

1,1-bis [p-methoxyphenyl]-2,2,2-trichloroethane;

1,2,5,6,9,10-hexabromocyclododecane;

1,10-dibromodecane;

1,1-bis [p-chlorophenyl]-2,2-dichloroethane;

4,4'-dichloro-2-(trichloromethyl) benzhydrol or 1,1-bis [p-chlorophenyl]-2,2,2-trichloroethanol;

hexachlorodimethyl sulfone;

2-chloro-6- (trichloromethyl) pyridine;

0,0-diethyl-0- (3,5,6-trichloro-2-pyridyl) phosphorothioate;

1,2,3,4,5,6-hexachlorocyclohexane;

N (1,1-bis [p-chlorophenyl]-2,2,2-trichloroethyl) acetamide;

tris [2,3-dibromopropyl] isocyanurate;

tris [2,3-dichloropropyl] phosphate;

1,1-bis [p-chlorophenyl]-2,2-dichloroethylene;

and their isomers and homologs;

(b) heating the deposited photosensitive solution to form a coating;

(c) exposing at least one portion of the coating to a source of actinic radiation having a wavelength in the range of about 299 nanometers or less;

(d) developing unexposed portion[s] of the coating with an aqueous base developer; and

(e) heating the exposed portion[s] of the coating to an elevated temperature to form a negative image that is thermally stable to temperatures in excess of 200° C.

We regard for the purpose of this invention, radiation having a wavelength of about 299 nanometers or less, such as deep UV radiation (i.e., radiation having a wavelength of from about 210 to about 299 nanometers) and x-rays to be accurately generically described as "short wavelength radiation". The useful photoacid generators are sensitive to short wave radiation, that is to say that they can be activated by at least one source of radiation having a wavelength in the stated range.

It is recognised that the lower the amount of photoacid generator in a photoresist composition and the lower the radiation dosage level required when exposing the photosensitive composition, the more effective is the photosensitive composition. We have now found that dosage levels of, for example, 150 mJ/cm$^2$ or less, preferably 10 mJ/cm$^2$ or less, in the case of deep UV irradiation, and 131 mJ/cm$^2$ or less, in the case

4

of x-ray irradiation, may be used with the photosensitive compositions of the invention. We have also found that the quantity of photoacid generator in the photosensitive composition of the invention may, for example, be from 0.1 to 50 percent by weight.

The photoacid generators, which we have found to be useful in combination with acid-hardening resin systems to form thermally stable, highly resolved and aqueously-developable, negative images on substrate surfaces, were empirically selected from a broad class of halogenated organic compounds.

In order for a photoacid generator to be useful in the present invention it is important that it meets a number of performance criteria:

1. The photoacid generator should be soluble in, or form a homogeneous solution with, the coating solution containing the desired acid-hardening resin system at a concentration sufficient to catalyze the crosslinking of the acid-hardening resin system upon exposure and heating;

2. The photoacid generator should not phase separate from the acid-hardening resin system when the resist is applied to the substrate, e.g. wafer, surface;

3. The photoacid generator, when activated by short wavelength actinic radiation, should be removable using a suitable aqueous base developer solution;

4. The photoacid generator should be non-reactive with the acid-hardening resin system components in the absence of the selected exposing radiation or with the substrate surface itself;

5. The photoacid generator should have no adverse effect on the adhesion, uniformity or quality of the photosensitive coating, containing an acid-hardening resin system, deposited on a substrate surface;

6. The photoacid generator should be capable of catalyzing the crosslinking of the acid-hardening resin system in the photosensitive coating upon exposure to deep UV or other short wavelength radiation, and heating to an elevated temperature, while not prematurely catalyzing the crosslinking reaction at ambient temperature;

7. The photoacid generator should be capable of so catalyzing the crosslinking of the acid-hardening resin system such that the negative image formed is thermally stable to temperatures in excess of 200°C;

8. The photoacid generator should be insensitive to radiation, other than the exposing radiation, so that the photosensitive composition is stable upon storage;

9. The photoacid generator should not substantially evaporate from the photoresist during "soft baking" (as hereinafter defined); and

10. The photoacid generator itself should be thermally stable so as not to generate acid during soft baking.

It is known that all organic compounds having halogen substituents are potential candidates for use as photoacid generators if they are capable of generating a halogen acid upon exposure to actinic radiation. Selection, from such halogenated organic compounds, of suitable candidate compounds for use as the photoacid generator in a particular photoresist composition having the above-stated properties, which properties are for the most part dependent on the other components present in that particular photoresist composition, is within the compass of a person of practical skill in the art and may be achieved by techniques involving nothing more than simple trial and error.

To determine if a halogenated compound is potentially useful as a deep UV photoacid generator we reviewed the absorption spectra of some commercially available halogenated organic compounds. Literature on the properties of 1,1-bis[p-chlorophenyl]-2,2,2-trichloroethane, commonly known as DDT, and its isomers, analogs, homologs and residual compounds is available due to its previous use as an insecticide (see, for example, H.C.A. Van Beck et. al., Ind. Eng. Chem. Process Res. Dev 21 123-125 (1982), and L. L. Miller et. al., J. Org Chem. 38 340 (1973)). We found that DDT has an absorption maximum at about 250 nanometers, which wavelength is very close to the deep UV radiation generated by mercury lamps used in microelectronic imaging equipment. Accordingly, we prepared a solution containing 2 weight percent DDT and an acid-hardening resin system consisting of 20 weight percent Cymel 303 aminoplast and 80 weight percent of a commercial reactive hydrogen containing cresol-formaldehyde novolak resin dissolved in Shipley Microposit Thinner solvent. The DDT formed a homogeneous solution with the acid-hardening resin composition. We then deposited the solution, as a coating, on a silicon wafer by spin coating the solution and then heating the coating at 90°C for 30 minutes ("soft baked") to remove the solvent, leaving an adherent coating of good quality and having a thickness of 1 to about 1.5 micrometers. We exposed the coating to a source of deep UV radiation having a wavelength of about 250 nanometers and an exposure dosage of about 10 millijoules per square centimeter (mJ/cm$^2$) through a standard metallized quartz photomask. After exposure, the wafer was baked at 90°C for 30 minutes. The unexposed areas were then removed using an aqueous base developer solution and the resulting images were examined and then slowly heated in a progressive step-wise manner to temperatures in excess of 300°C. The image quality and resolution was examined during this process and it was found that thermally stable images of high resolution were maintained.

We then attempted to determine whether chemically related halogenated organic compounds were sensitive to deep UV and met the other performance criteria important to function as a photoacid generator in combination with an acid-hardening resin system to produce aqueously-developable, thermally stable negative images using the screening process described above. We found that a correlation exists between the absorption spectra of halogenated organic compounds, their sensitivity to deep UV radiation and their capability of being used with acid-hardening resin systems. If the absorption maximum of the halogenated material is in the range of about 210 nanometers (i.e. the lowest wavelength capable of being determined using conventional quartz containers and spectral analysis) to 299 nanometers, the material is a potential deep UV photoacid generator because this absorption maxima range is sufficiently close to the deep UV radiation produced with conventional imaging equipment. We examined halogenated organic compounds which had an absorption maximum in this range by following the procedure described above. We used the halogenated organic compound at a concentration of 5 weight percent and exposed a coating formed from a photosensitive composition containing the potential photoacid generator and acid-hardening resin to 254 nanometer wavelength deep UV radiation at a dosage of 10 mJ/cm$^2$. While some potentially useful halogenated organic compounds which exhibited only a low level of absorption sensitivity to deep UV radiation in the 210 to 299 nanometer range were found to be useful as photoacid generators with acid-hardening resin systems, other potentially useful photoacid generators having a similar absorption spectra maximum (low extinction coefficient) were found to be unsuitable for use as photoacid generators with acid-hardening resin systems at the concentration, wavelength and dosage levels of the test. The absorption spectra of a halogenated organic compound, therefore, can only identify potentially useful photoacid generators but cannot be used to predict whether the halogenated organic compound can be used in combination with acid-hardening resins to produce aqueously developable, highly resolved and thermally stable negative images using deep UV exposure. For example, certain halogenated organic compounds possess too high a vapor pressure to yield microlithographically consistent and acceptable negative images. Chloroform, for example, appreciably volatilizes upon the soft baking (90°C for 30 minutes) step used to remove the solvent from the deposited coating. As a result, the final concentration of chloroform remaining in the coating may be too low to sufficiently catalyze the acid-hardening reaction uniformly throughout the coating. In addition, slight coating thickness variations may also lead to differing concentrations of the photoacid generator in the coating such that the images which are formed crosslink to different degrees and yield inconsistent resolution (line widths) on the surface. Other potentially useful halogenated organic compounds were found to lack thermal stability. That is, they did not resist generating acid during the softbaking step used to remove the solvent from the film. If the photoacid generator yields acid during the softbaking step the acid-hardening resin system will crosslink prematurely. Premature crosslinking will lead to a crosslinked, non-imageable coating on the surface.

Therefore, in order for a photoacid generator to be useful in the present invention, in combination with an acid-hardening resin system, it should also have a low enough vapor pressure such that substantially no evaporation of the photoacid generator occurs upon softbaking the coating, and the photoacid generator should possess sufficient resistance towards premature activation during the softbaking step.

We have found a number of halogenated organic materials which are suitable for use as photoacid generators, in combination with acid-hardening resin systems, to produce highly resolved, thermally stable, and aqueously-developable negative images on exposure to deep UV at doses of 10 mJ/cm$^2$ or less when employed in the photosensitive composition at a concentration of about 5 weight percent or less. These deep UV sensitive photoacid generators are:

1,1-bis [p-chlorophenyl]-2,2,2-trichloroethane (DDT);

1,1-bis [p-methoxyphenyl]-2,2,2-trichloroethane;

1,2,5,6,9,10-hexabromocyclododecane;

1,10-dibromodecane;

1,1-bis[p-chlorophenyl]-2,2-dichloroethane;

4,4'-dichloro-2-(trichloromethyl) benzhydrol or 1,1-bis(p-chlorophenyl)2,2,2-trichloroethane (Kelthane);

hexachlorodimethyl sulfone;

2-chloro-6-(trichloromethyl) pyridine;

0,0-diethyl-0-(3,5,6-trichloro-2-pyridyl)phosphorothioate (Dursban)

1,2,3,4,5,6-hexachlorocyclohexane;

N(1,1-bis [p-chlorophenyl]-2,2,2-trichloroethyl)-acetamide,

tris [2,3-dibromopropyl] isocyanurate;

tris [2,3-dichloropropyl] phosphate;

6

2,2-bis [p-chlorophenyl]-1,1-dichloroethylene;
and their isomers and homologs.

The preferred deep UV sensitive photoacid generators are those which are useful in combination with acid-hardening resin systems at concentrations as low as about 0.1, e.g. from about 0.1 to 10, preferably about 0.1 to 5, weight percent when the exposure dosage of deep UV radiation is 10 mJ/cm². The preferred deep UV sensitive photoacid generators are: DDT, Methoxychlor, Kelthane, and tris (2,3-dibromopropyl)-isocyanurate.

In addition to evaluating and selecting halogenated organic compounds which are useful for forming thermally stable, aqueously-developable, negative images using deep UV radiation, we also examined whether these photoacid generators, in combination with acid-hardening resins, could be used to produce aqueously-developable, thermally stable negative images using x-ray exposure. The illustrative examples which follow demonstrate the results of our experiments with x-ray exposure and negative image formation.

Some of the photoacid generators which were found to be useful as deep UV sensitive photoacid generators were found to be not useful as x-ray sensitive photoacid generators and two compounds, namely, tris[2,3-dichloropropyl]phosphate and tris[2-chloroethyl]phosphate, which were not useful as deep UV sensitive photoacid generators were found to be useful as x-ray sensitive photoacid generators. Suitable x-ray photoacid generators include:-
1,1-bis[p-chlorophenyl]-2,2,2-trichloroethane;
4,4′-dichloro-2-(trichloromethyl)benzhydrol;
0,0-diethyl-0-(3,5,6,-trichloro-2-pyridyl)-phosphorothioate;
1,2,3,4,5,6-hexachlorocyclohexane (B-isomer);
N(1,1-bis[p-chlorophenyl]-2,2,2,-trichloroethyl)-acetamide;
tris[2,3,-dibromopropyl]isocyanurate; and
tris[2,3-dichloropropyl]phosphate.

When the photoacid generators were employed with the acid-hardening resin system for x-ray imaging, the minimum concentration of the photoacid generator in the photosensitive composition was found to be much higher than when the same photoacid generator is used as a deep UV sensitive photoacid generator. The minimum concentration of the photoacid generator in the x-ray imagable photosensitive compositions was found to be about 10 weight percent and typically in the range of from about 10 weight percent to about 50 weight percent. Despite the need for much higher concentrations of photoacid generator in the photosensitive composition when employing x-ray exposure rather than deep UV exposure, the resulting image resolution of the x-ray exposed negative resist was higher (more resolved) than for deep UV exposure. Because x-rays have very small wavelengths, of about 0.1 to 10 nanometers, they inherently have the capability of yielding very highly resolved images. See, for example, Introduction to Microlithography, ACS Sys. Series No. 219, ACS, Washington, D.C. 1983 p. 138-140. This reference also correlates x-ray sensitivity to electron beam and proton beam sensitivity. The conclusion reached is that the basic radiation chemistry which an x-ray resist undergoes is the same for other various forms of short wavelength radiation. Accordingly, the x-ray sensitive resists of the present invention may also be useful when exposed to such other short wavelength actinic radiation.

Very highly resolved submicrometer images of about 0.2 to 1 micrometer are capable of being produced with photosensitive compositions in accordance with the present invention using an x-ray source containing a palladium target, operated at 20,000 volts, manufactured by Micronix.

It is generally accepted that x-rays typically generate secondary electrons within the photoresist. These secondary electrons interact with the photoacid generator to produce a halogen acid capable of catalyzing the crosslinking of an acid hardening resin. Therefore, it follows that in addition to x-rays the photosensitive compositions of the present invention, employing the selected x-ray sensitive photoacid generators, have the capability of being imaged using other short wavelength radiations such as electron beams. Electron beam imaging of these photosensitive compositions may be used to prepare photomasks where extremely high resolution of approximately 0.1 micrometer is desired.

Suitable acid-hardening resin systems, which can be combined with the photoacid generators described herein, include those described in detail in our EP-A-0164248. The acid-hardening resin system contains a polymer that crosslinks in the presence of an acid catalyst and heat. The acid-hardening resin system may be prepared from a variety of aminoplast or phenoplasts in combination with compounds or low molecular weight polymers containing a plurality of hydroxyl, carboxyl, amide or imide groups Suitable aminoplasts include: urea-formaldehyde; melamine-formaldehyde; benzoguanamine-formaldehyde; glycoluril-formaldehyde resins; and combinations thereof. The aminoplasts are used in combination with a reactive hydrogen-containing compound such as a novolak resin; polyvinylphenol; polyglutarimide; poly(meth)acrylic acid copolymers; alkali-soluble polyacrylamide and polymethacrylamide copolymers; copolymers containing 2-

7

hydroxyethyl acrylate or methacrylate; polyvinyl alcohols such as those prepared from partially hydrolyzed polyvinyl acetates; alkali-soluble styrene-allylalcohol copolymers; and mixtures thereof. Preferred reactive hydrogen-containing compounds are novolak resins containing hydroxyl groups, sites for the electrophillic substitution of aromatic rings at positions ortho- or para- relative to the hydroxyl group, and a weight average molecular weight ranging from about 300 to 100,000 and more preferably from about 1,000 to about 20,000.

The acid-hardening resin system can also be prepared from a combination of phenoplast resins and a latent formaldehyde-generating compound. These latent formaldehyde-generating compounds include s-trioxane, N(2-hydroxyethyl) oxazolidine and oxazolidinylethyl methacrylate.

The acid-hardening resin system should be soluble in suitable non-reacting solvents, for example glycolethers such as ethylene glycol monomethylether, ethylene glycol monoethylether, Propasol P and Propasol B; Cellosolve esters such as methyl Cellosolve acetate, ethyl Cellosolve acetate and acetates of Propasol B and P; aromatic hydrocarbons such as toluene and xylene; ketones such as methylethyl ketone, cyclopentanone and cyclohexanone; esters such as ethyl acetate, butyl acetate, isobutyl isobutyrate and butyrolactone; amides such as dimethylacetamide (DMAC), N-methylpyrrolidinone (NMP) and dimethylformamide (DMF); chlorinated hydrocarbons such as ethylene dichloride, chlorobenzene and ortho-dichlorobenzene; nitrobenzene; dimethylsulfoxide; and mixtures thereof. The photosensitive coating solution typically contains at least 50 percent by weight solvent and preferably from about 65 to 95 percent by weight solvent.

The deep UV photosensitive compositions of the invention may contain (i) from about 3 to about 50 parts by weight aminoplast resin, about 40 to about 90 parts by weight reactive hydrogen-generating compound and from about 0.1 to about 10 parts by weight of the photoacid generator, or (ii) from about 3 to about 50 parts by weight phenoplast, from about 40 to about 90 parts by weight formaldehyde-generating compound and about 0.1 to about 10 parts by weight photoacid generator.

The x-ray photosensitive compositions of the invention may contain (i) from about 3 to about 50 parts by weight aminoplast, from about 40 to about 90 parts by weight reactive hydrogen-generating compound, and from about 10 to about 50 parts by weight x-ray, photoacid generator, or (ii) from about 3 to about 50 parts by weight phenoplast, from about 40 to about 90 parts by weight latent formaldehyde-generating compound, and from about 10 to about 50 parts by weight x-ray, photoacid generator.

The use of photosensitive compositions according to the present invention to produce aqueous-developed, thermally stable and highly resolved negative images on substrate surfaces will now be further illustrated by way of the following Examples which are for illustrative purposes only and are not to be construed as imposing any limitation on the scope of the present invention. In the Examples, all percentages are percentages by weight unless otherwise indicated.

EXAMPLE 1

Formation of Negative Images using deep UV by Contact Printing

Preparation of coating solution:-

To 10.0 grams of a 30% solids proprietary novolak resin (solution), Shipley Company XP-0103, was added 0.60 g of methylated melamine-formaldehyde aminoplast, Cymel 303, and 0.73 g of a 10% solution of 1,1-bis[p-chlorophenyl]-2,2,2-trichloroethane photoacid generator dissolved in Shipley Microposit Type A Thinner. A further 2.4g Shipley Microposit Type A thinner was then added to produce a mixture which contained 1.99% photoacid generator (by weight of solids) and 26.73% solids. The mixture was gently agitated for 5 minutes at 25°C to form a homogeneous solution.

Coating Procedure (A):

A 7.62 cm (3 in) diameter silicon oxide wafer was vapor primed (5 min.) with hexamethyldisilazane (HMDS) to remove surface moisture. A 1.0 ml aliquot of the coating solution was placed onto the wafer and spin-coated at 3000 pm for 60 seconds. The wafer was then placed in a forced air oven at 90°C for 30 min (soft baking). The wafer was then placed in contact with a Shipley Target photomask using a Hybrid Technology Group Model No. L-84-5X contact printer. The coating was exposed to actinic radiation at 254 nm from a high pressure mercury vapor lamp (500 watt) fitted with an Action Research bandpass filter of peak wavelength 258.5 nm and a bandwidth of 28 nm. The wafer received a radiation exposure of 7.5. millijoule per square centimeter (mJ/cm$^2$). Following exposure and removal of the photomask, the acid latent image in the exposed regions of the coating was crosslinked by heating the coating at 90°C for 30 min. in a forced-air oven. The images were developed in an aqueous base developer, Shipley Company Microposit 351 developer, diluted two parts by volume with three parts by volume deionized water, for 2.75 minutes at 20°C with mild agitation. The resultant images were 1.4 $\mu$m thick.

Coating Procedure (B):

A resist solution similar to the one above was diluted to 26% solids and processed according to the procedure (A) to produce 0.7 $\mu$m lines and spaces.

EXAMPLE 2

Formation of Negative Image using deep UV and a Commercial Exposure System

A resist solution of 2% 1,1-bis[p-chlorophenyl]-2,2,2,-trichloroethane was prepared in a similar manner to Example 1. The coating solution was taken to Perkin-Elmer research labs of South, Wilton, CT. where it was spin-coated onto an HMDS-primed 12.7 cm (5 in) silicon oxide wafer at 3500xpm for 45 sec. The coating was softbaked at 90°C for 40 min in a forced-air oven before exposure on a Perkin-Elmer Micralign 540 aligner. A 280 nm bandpass filter of peak wavelength 280nm and bandwidth of 50 nm was placed between a deep UV lamp and the aligned mask/wafer system. The wafer was exposed to a series of five doses across the wafer surface, by changing the scan speed of the radiation. A proprietary Perkin-Elmer test pattern (on a dark-field mask) was used to image the coating to doses of 2.2, 3.9, 5.5, 7.2 and 8.8 mJ/cm$^2$ radiation. The exposed wafer was processed in a similar manner to Example 1 to produce approximately 0.9 $\mu$m thick images.

EXAMPLE 3

Formation of Negative Images using X-rays

A resist solution of 2% 1,1-bis-[p-chlorophenyl]-2,2,2-trichloroethane was prepared by combining 10.00 g novolak resin, 0.60 g Cymel 303, 0.73 g of a 10% solution photoacid generator dissolved in Shipley Microposit Type A Thinner. An additional 2.40 g thinner was then added. The solution was spin-coated and baked onto a 10.16 cm (4 in) wafer as described in Example 1, before taking to Micronix Corp. of Los Gatos, CA. At Micronix, the coating was soaked in deionized water for 10 min before placing in a prototype x-ray exposure system, using a 2.5KW palladium source and 25KV which produces a sharp x-ray line at 3 Angstroms superimposed on less intense broadband of x-rays. A proprietary Micronix test metallized photomask was placed between the x-ray source and the wafer stage. The side of the mask facing the source was exposed to a helium atmosphere, and the side opposite exposed to normal atmosphere. The wafer was then placed under the mask, the gap between the mask and the wafer being 40 micrometers and exposed for 60 min. using an air purge over the wafer surface. This was equivalent to a dose of 131 mJ/cm$^2$. After a 93°C, 23 min postbake, the 1.3$\mu$m thick coating was developed in a 3/2 solution of Shipley 351 aqueous developer/deionized water until the unexposed areas were clear (2-3 min.) 0.96$\mu$m images were produced (80% initial thickness retained).

The developed coating had a uniformity comparable to a conventional DCOPA x-ray resist and a ring of thinner coating at the outer edge.

The 1.0 $\mu$m bars from the photomask were not resolved, which indicated over-exposure. However, image profile was superior to DCOPA (which is slanted and rounded).

Table 1 presents a key to the photoacid generators employed in the following Examples in combination with acid-hardening resins to produce negative images. The procedures used to prepare the photosensitive composition, coating and negative image are the same as described in Example 1 with deep UV and Example 2 with x-rays, except for the changes identified in Tables 2 to 4.

# EP 0 232 972 B1

## TABLE 1

| PHOTOACID GENERATORS | |
|---|---|
| PHOTOACID GENERATOR NUMBER | NAME |
| 1. | 1,1-bis[p-chlorophenyl]-2,2,2-trichloroethane |
| 2. | 1,1-bis[p-methoxyphenyl]-2,2,2-trichloroethane |
| 3. | 1,2,5,6,9,10-hexabromocyclododecane |
| 4. | 1,10-dibromodecane |
| 5. | 1,1,-bis[p-chlorophenyl]-2,2-dichloroethane |
| 6. | 4,4′-dichloro-2-(trichloromethyl)benzhydrol |
| 7. | hexachlorodimethylsulfone |
| 8. | 2-chloro-6-(trichloromethyl)pyridine |
| 9. | 0,0-diethyl-0-(3,5,6,-trichloro-2-pyridyl)-phosphorothioate |
| 10. | 1,2,3,4,5,6-hexachlorocyclohexane (B-isomer) |
| 11. | N(1,1-bis[p-chlorophenyl]-2,2,2,-trichloroethyl)-acetamide |
| 12. | tris[2,3,-dibromopropyl]isocyanurate |
| 13. | 1,1-bis[p-chlorophenyl]-2,2-dichloroethylene |
| 14. | UVE1014 onium salt (manufactured by General Electric Co.) |
| 15. | FC-508 onium salt(UV activated Epoxy Curing Agent) manufactured by 3M Corp. |
| 16. | trichloroacetamide |
| 17. | trifluoroacetamide |
| 18. | 1,4-dibromobutanol |
| 19. | o-nitrobenzaldehyde |
| 20. | trifluoromethylphenol |
| 21. | bis[o-nitrobenzyl]azelate |
| 22. | 2′-nitrobenzanilide |
| 23. | 1,1-dichloro-2,2-bis[p-ethylphenyl]ethane |
| 24. | tris[2,3-dichloropropyl]phosphate |
| 25. | 1,4-bis[trichloromethyl]benzene |
| 26. | tris[2-chloroethyl]phosphate |
| 27. | dibenzylsulfoxide |
| 28. | 9-chloromethylanthracene |
| 29. | alpha-tetraloneoxime p-toluenesulfonate |

## EXAMPLES 4-87

Table 2 presents the results of experiments performed with a number of deep UV photoacid generators in combination with acid-hardening resins using deep UV exposure. These photosensitive compositions produced aqueously-developable, thermally stable, highly resolved negative images.

Examples 73, 76, 78, 80 to 82, 86 and 87 are comparative examples, the wavelength of the radiation being in the near UV range, and are included to show that with near UV irradiation of the stated photoacid generators unacceptably high dosages of irradiation are required than when deep UV irradiation is used.

10

TABLE 2 - PHOTOSENSITIVE COMPOSITIONS
USING DEEP UV PHOTOACID GENERATORS

| Example No. | P.G.[1] | WEIGHT % P.G. | AHRS[2] | WEIGHT RATIO NOV/C303 | COATING THICK-NESS $\mu$m[7] | EXPOSURE WAVE-LENGTH (nm) | DOSE mJ/cm[2] | MASK | POSTBAKE °C/MINS. | DEVELOP MIN. | DILUTION D/W[13] | D[12] | HEAT TREAT-MENT °C/MIN. |
|---|---|---|---|---|---|---|---|---|---|---|---|---|---|
| 4 | 1 | 25 | NOV[3]/C303[4] | 5/1 | 0.7 | 254 | 1 | R[5] | 90/30 | -- | 0.5/1 | 351 | -- |
| 5 | 1 | 10 | NOV[3]/C303[4] | 5/1 | 2.7 | 254 | 63 | 3D[6] | 90/30 | 5.75 | 1/1 | 351 | -- |
| 6 | 1 | 5 | NOV[3]/C303[4] | 5/1 | 0.9 | 280 | 2.5 | NEG. TONE | 90/30 | -- | 1.5/1 | 351 | -- |
| 7 | 1 | 2 | NOV[3]/C303[4] | 5/1 | 2.5 | 254 | 63 | 3D[6] | 90/30 | 1.6 | 1/1 | 351 | -- |
| 8 | 1 | 2 | NOV[3]/C303[4] | 5/1 | 0.9 | 280 | 3-4 | POS. TONE | 90/30 | -- | 1.5/1 | 351 | -- |
| 9 | 1 | 2 | NOV[3]/C303[4] | 5/1 | 1.0 | 254 | 8 | R[5] | 90/30 | 1.6 | 1.5/1 | 351 | -- |

EP 0 232 972 B1

## Table 2 (Cont.)

| Example No. | P.G.[1] | WEIGHT % P.G. | AHRS[2] | WEIGHT RATIO NOV/C303 | COATING THICK-NESS $\mu m$[7] | EXPOSURE WAVE-LENGTH (nm) | DOSE mJ/ $cm^2$ | MASK | POSTBAKE °C/MINS. | DEVELOP MIN. DILUTION D/W[13] D[12] | | HEAT TREAT-MENT °C/MIN. |
|---|---|---|---|---|---|---|---|---|---|---|---|---|
| 10 | 1 | 2 | NOV[3]/C303[4] | 5/1 | 2.2 | 254 | 10 | R[5] | 90/30 | 4.7 | 1.5/1 351 | -- |
| 11 | 1 | 2 | NOV[3]/C303[4] | 5/1 | 1.3 | 254 | 8 | R[5] | 90/30 | 2.5- | 1.5/1 351 | 300/15 |
| 12 | 1 | 2 | NOV[3]/C303[4] | 5/1 | 1.5 | 254 | 7.5 | R[5] | 90/30 | 2.45 | 1.5/1 351 | 300/15 |
| 13 | 1 | 2 | NOV[3]/C303[4] | 5/1 | 1.5 | 254 | 7.5 | R[5] | 90/30 | 3.0 | 1.5/1 351 | 300/15 |
| 14 | 1 | 2 | NOV[3]/C303[4] | 8/1 | 1.3 | 254 | 8 | R[5] | 90/30 | 2.5 | 1.5/1 351 | -- |
| 15 | 1 | 2 | NOV[3]/C303[4] | 8/1 | 1.4 | 254 | 7.5 | R[5] | 90/30 | 2.0 | 1.5/1 351 | 300/15 |
| 16 | 1 | 2 | NOV[3]/C303[4] | 4/1 | 1.5 | 254 | 8 | R[5] | 90/30 | 3.0 | 1.5/1 351 | -- |
| 17 | 1 | 2 | NOV[3]/C303[4] | 4/1 | 1.5 | 254 | 7.5 | R[5] | 90/30 | 2.2 | 1.5/1 351 | 300/15 |

Table 2 (Cont.)

| Example No. | P.G.[1] | WEIGHT % P.G. | AHRS[2] | WEIGHT RATIO NOV/C303 | COATING THICK-NESS $\mu m$[7] | EXPOSURE WAVE-LENGTH (nm) | DOSE mJ/ $cm^2$ | MASK | POSTBAKE °C/MINS. | DEVELOP MIN. D/W[13] | DILUTION D[12] | HEAT TREAT-MENT °C/MIN. |
|---|---|---|---|---|---|---|---|---|---|---|---|---|
| 18 | 1 | 2 | NOV[3]/C303[4] | 2.7/1 | 1.6 | 254 | 8 | R[5] | 90/30 | 2.7 | 1.5/1 351 | -- |
| 19 | 1 | 2 | NOV[3]/C303[4] | 2.7/1 | 1.6 | 254 | 7.5 | R[5] | 90/30 | 1.8 | 1.5/1 351 | 300/15 |
| 20 | 1 | 2 | NOV[3]/C303[4] | 1.9/1 | 1.7 | 254 | 8 | R[5] | 90/30 | 2.0 | 1.5/1 351 | -- |
| 21 | 1 | 2 | NOV[3]/C303[4] | 1.9/1 | 1.7 | 254 | 7.5 | R[5] | 90/30 | 1.5 | 1.5/1 351 | 300/15 |
| 22 | 1 | 2 | NOV[3]/C303[4] | 1.6/1 | 1.9 | 254 | 8 | R[5] | 90/30 | 1.5 | 1.5/1 351 | -- |
| 23 | 1 | 2 | NOV[3]/C303[4] | 1.6/1 | 1.7 | 254 | 7.5 | R[5] | 90/30 | 1.0 | 1.5/1 351 | -- |
| 24 | 1 | 1 | NOV[3]/C303[4] | 5/1 | 2.5 | 254 | 63 | 3D[6] | 90/30 | 4.7 | 2/1 351 | -- |
| 25 | 1 | 1 | NOV[3]/C303[4] | 5/1 | 1.6 | 254 | 5 | 3D[6] | 90/30 | 2-3 | 2/1 351 | -- |
| 26 | 1 | 1 | NOV[3]/C303[4] | 5/1 | 2.6-2.8 | 254 | 60 | 3D[6] | 90/30 | 4.5 | 2/1 351 | -- |

EP 0 232 972 B1

## Table 2 (Cont.)

| Example No. | P.G.[1] | WEIGHT % P.G. | AHRS[2] | WEIGHT RATIO NOV/C303 | COATING THICK-NESS μm[7] | EXPOSURE WAVE-LENGTH (nm) | DOSE mJ/cm[2] | MASK | POSTBAKE °C/MINS. | DEVELOP MIN. D/W[13] | DEVELOP DILUTION | DEVELOP D[12] | HEAT TREAT-MENT °C/MIN. |
|---|---|---|---|---|---|---|---|---|---|---|---|---|---|
| 27 | 1 | 1 | NOV[3]/C303[4] | 5/1 | 1.3 | 220 | 23 | STEN[11] | 90/30 | -- | 1.5/1 | 351 | -- |
| 28 | 1 | 1 | NOV[3]/C303[4] | 5/1 | 1.3 | 220 | 115 | STEN[11] | 90/30 | -- | 1.5/1 | 351 | -- |
| 29 | 1 | 1 | NOV[3]/B60[8] | 5/1 | 1.6 | 254 | 63 | 3D[6] | 90/30 | 1.2 | 2/1 | 351 | -- |
| 30 | 1 | 1 | NOV[3]/C1123[9] | 5/1 | 1.5 | 254 | 63 | 3D[6] | 90/30 | 7.5 | 2/1 | 351 | -- |
| 31 | 1 | 1 | PVP[10]/C303[4] | 5/1 | 1.9 | 254 | 10 | 3D[6] | 90/30 | 9.0 | 11/1 | 351 | -- |
| 32 | 2 | 5 | NOV[3]/C303[4] | 5/1 | 0.9 | 280 | 2.5 | NEG. TONE | 90/30 | -- | 1.5/1 | 351 | -- |
| 33 | 2 | 2 | NOV[3]/C303[4] | 5.1 | 1.5 | 254 | 5 | R[5] | 100/25 | 5.5 | 1.5/1 | 351 | -- |
| 34 | 2 | 2 | NOV[3]/C303[4] | 5/1 | 1.5 | 254 | 9 | R[5] | 90°C/30 | 2.2 | 1.5/1 | 351 | -- |

EP 0 232 972 B1

Table 2 (Cont.)

| Example No. | P.G.[1] | WEIGHT % P.G. | AHRS[2] | WEIGHT RATIO NOV/C303 | COATING THICK- NESS $\mu m$[7] | EXPOSURE WAVE- LENGTH (nm) | DOSE mJ/ $cm^2$ | MASK | POSTBAKE °C/MINS. | DEVELOP MIN. DILUTION D/W[13] D[12] | | HEAT TREAT- MENT °C/MIN. |
|---|---|---|---|---|---|---|---|---|---|---|---|---|
| 35 | 2 | 2 | NOV[3]/C303[4] | 5/1 | 1.5 | 254 | 4 | R[5] | 100/15 | 3.6 | 1.5/1 351 | -- |
| 36 | 2 | 2 | NOV[3]/C303[4] | 5/1 | 1.3 | 220 | 23 | STEN[11] | 90/30 | 3.6 | 1.5/1 351 | -- |
| 37 | 2 | 2 | NOV[3]/C303[4] | 5/1 | 0.9 | 280 | 8-9 | POS. TONE | 90/30 | -- | 1.5/1 351 | -- |
| 38 | 2 | 2 | NOV[3]/C303[4] | 5/1 | 1.0 | 254 | 3 | R[5] | 90/30 | 1.9 | 1.5/1 351 | -- |
| 39 | 2 | 1 | NOV[3]/C303[4] | 5/1 | 1.6 | 254 | 63 | 3D[6] | 90/30 | 2.05 | 2/1 351 | -- |
| 40 | 2 | 1 | NOV[3]/C303[4] | 5/1 | 1.5 | 254 | 5 | R[5] | 100/30 | 7.25 | 2/1 351 | -- |
| 41 | 2 | 1 | NOV[3]/C303[4] | 5/1 | 1.5 | 254 | 5 | R[5] | 100/25 | 4.5 | 1.5/1 351 | -- |
| 42 | 3 | 5 | NOV[3]/C303[4] | 5/1 | 0.94 | 254 | 10 | 3D[6] | 90/30 | 3.0 | 2/1 351 | -- |

Table 2 (Cont.)

| Example No. | P.G.[1] | WEIGHT % P.G. | AHRS[2] | WEIGHT RATIO NOV/C303 | COATING THICK-NESS $\mu m$[7] | EXPOSURE WAVE-LENGTH (nm) | DOSE mJ/ $cm^2$ | MASK | POSTBAKE °C/MINS. | DEVELOP MIN. D/W[13] | DILUTION D[12] | HEAT TREAT-MENT °C/MIN. |
|---|---|---|---|---|---|---|---|---|---|---|---|---|
| 43 | 3 | 5 | NOV[3]/C303[4] | 5/1 | 0.9 | 280 | 10 | NEG. TONE | 90/30 | 3.0 | 2/1 351 | -- |
| 44 | 3 | 2 | NOV[3]/C303[4] | 5/1 | 1.3 | 220 | 23 | STEN[11] | 90/30 | -- | 1.5/1 351 | -- |
| 45 | 3 | 2 | NOV[3]/C303[4] | 5/1 | 1.3 | 220 | 115 | STEN[11] | 90/30 | -- | 1.5/1 351 | -- |
| 46 | 3 | 2 | NOV[3]/C303[4] | 5/1 | 0.9 | 280 | 9-10 | POS. TONE | 90/30 | -- | 1.5/1 351 | -- |
| 47 | 3 | 2 | NOV[3]/C303[4] | 5/1 | 1.0 | 254 | 5 | R[5] | 90/30 | 1.2 | 1.5/1 351 | -- |
| 48 | 4 | 5 | NOV[3]/C303[4] | 5/1 | 0.91 | 254 | 10 | 3D[6] | 90/30 | 2.3 | 2/1 351 | -- |
| 49 | 5 | 5 | NOV[3]/C303[4] | 5/1 | 1.0 | 254 | 10 | 3D[6] | 90/30 | 4.0 | 2/1 351 | -- |
| 50 | 5 | 5 | NOV[3]/C303[4] | 5/1 | 1.0 | 254 | 20 | | 90/30 | 4.4 | 2/1 351 | -- |

EP 0 232 972 B1

## Table 2 (Cont.)

| Example No. | P.G.[1] | WEIGHT % P.G. | AHRS[2] | WEIGHT RATIO NOV/C303 | COATING THICK-NESS $\mu m$[7] | EXPOSURE WAVE-LENGTH (nm) | DOSE mJ/ $cm^2$ | MASK | POSTBAKE °C/MINS. | DEVELOP MIN. D/W[13] | DILUTION D[12] | HEAT TREAT-MENT °C/MIN. |
|---|---|---|---|---|---|---|---|---|---|---|---|---|
| 51 | 6 | 25 | NOV[3]/C303[4] | 5/1 | 0.5 | 254 | 1 | R[5] | 90/30 | -- | 0.5/1 351 | -- |
| 52 | 6 | 25 | NOV[3]/C303[4] | 5/1 | 1.0 | 254 | 1 | R[5] | 90/30 | -- | 0.5/1 351 | -- |
| 53 | 6 | 20 | NOV[3]/C303[4] | 5/1 | 0.6 | 254 | 15 | R[5] | 90/30 | -- | 0.5/1 351 | -- |
| 54 | 6 | 15 | NOV[3]/C303[4] | 5/1 | 0.6 | 254 | 2.5 | R[5] | 90/30 | -- | 0.5/1 351 | -- |
| 55 | 6 | 10 | NOV[3]/C303[4] | 5/1 | 0.6 | 254 | 3.5 | R[5] | 90/30 | -- | 0.5/1 351 | -- |
| 56 | 6 | 5 | NOV[3]/C303[4] | 5/1 | 1.0 | 254 | 10 | NEG. TONE | 90/30 | -- | 1.5/1 351 | -- |
| 57 | 6 | 5 | NOV[3]/C303[4] | 5/1 | 0.9 | 280 | 2.5 | POS. TONE | 90/30 | -- | 1.5/1 351 | -- |

## Table 2 (Cont.)

| Example No. | P.G.[1] | WEIGHT % P.G. | AHRS[2] | WEIGHT RATIO NOV/C303 | COATING THICK-NESS μm[7] | EXPOSURE WAVE-LENGTH (nm) | DOSE mJ/cm[2] | MASK | POSTBAKE °C/MINS. | DEVELOP MIN. | DILUTION D/W[13] | D[12] | HEAT TREAT-MENT °C/MIN. |
|---|---|---|---|---|---|---|---|---|---|---|---|---|---|
| 58 | 6 | 2 | NOV[3]/C303[4] | 5/1 | 0.9 | 280 | 7.8 | POS TONE | 90/30 | -- | 1.5/1 | 351 | -- |
| 59 | 6 | 1.9 | NOV[3]/C303[4] | 5/1 | 1.0 | 254 | 5.5 | R[5] | 90/30 | 1.9 | 1.5/1 | 351 | -- |
| 60 | 7 | 5 | NOV[3]/C303[4] | 5/1 | 1.0 | 254 | 1.0 | 3D[6] | 90/30 | 4.2 | 2/1 | 351 | -- |
| 61 | 8 | 5 | NOV[3]/C303[4] | 5/1 | 1.0 | 254 | 1.0 | 3D[6] | 90/30 | 2.5 | 2/1 | 351 | -- |
| 62 | 9 | 5 | NOV[3]/C303[4] | 5/1 | 1.0 | 254 | 1.0 | 3D[6] | 90/30 | 3.0 | 2/1 | 351 | -- |
| 63 | 10 | 5 | NOV[3]/C303[4] | 5/1 | 1.0 | 254 | 1.0 | 3D[6] | 90/30 | 1.8 | 2/1 | 351 | -- |
| 64 | 11 | 5 | NOV[3]/C303[4] | 5/1 | 1.0 | 254 | 6 | | 90/30 | 6.0 | 2/1 | 351 | -- |
| 65 | 12 | 5 | NOV[3]/C303[4] | 5/1 | 1.0 | 254 | 6 | | 90/30 | 2.2 | 2/1 | 351 | -- |

Table 2 (Cont.)

| Example No. | P.G.[1] | WEIGHT % P.G. | AHRS[2] | WEIGHT RATIO NOV/C303 | COATING THICK- NESS $\mu m^7$ | EXPOSURE WAVE- LENGTH (nm) | DOSE mJ/ $cm^2$ | MASK | POSTBAKE °C/MINS. | DEVELOP MIN. | DILUTION D/W[13] D[12] | HEAT TREAT- MENT °C/MIN. |
|---|---|---|---|---|---|---|---|---|---|---|---|---|
| 66 | 12 | 5 | NOV[3]/C303[4] | 5/1 | 0.9 | 280 | 10 | NEG. TONE | 90/30 | -- | 1.5/1 351 | -- |
| 67 | 12 | 2 | NOV[3]/C303[4] | 5/1 | 0.9 | 280 | 9-10 | POS. TONE | 90/30 | -- | 1.5/1 351 | -- |
| 68 | 12 | 2 | NOV[3]/C303[4] | 5/1 | 1.0 | 254 | 11.5 | R[5] | 90/30 | 1.5 | 1.5/1 351 | -- |
| 69 | 12 | 2 | NOV[3]/C303[4] | 5/1 | 1.0 | 254 | 11.0 | R[5] | 90/30 | 1.7 | 1.5/1 351 | -- |
| 70 | 13 | 5 | NOV[3]/C303[4] | 5/1 | 1.0 | 254 | 6 | | 90/30 | 3.8 | 2/1 351 | -- |
| 71 | 14 | 5 | NOV[3]/C303[4] | 5/1 | 1.0 | 254 | 9.6 | | 90/30 | 3.4 | 2/1 351 | -- |
| 72 | 14 | 5 | NOV[3]/C303[4] | 5/1 | 2.9 | 254 | 2.0 | 3D[6] | 90/30 | 4.25 | 1/1 351 | -- |
| 73 | 14 | 5 | NOV[3]/C303[4] | 5/1 | 2.9 | 365 | 1000 | 3D[6] | 90/30 | 7.7 | 1.5/1 351 | -- |

EP 0 232 972 B1

Table 2 (Cont.)

| Example No. | P.G.[1] | WEIGHT % P.G. | AHRS[2] | WEIGHT RATIO NOV/C303 | COATING THICK-NESS μm[7] | EXPOSURE WAVE-LENGTH (nm) | DOSE mJ/cm[2] | MASK | POSTBAKE °C/MINS. | DEVELOP MIN. D/W[13] | DILUTION D[12] | HEAT TREATMENT °C/MIN. |
|---|---|---|---|---|---|---|---|---|---|---|---|---|
| 74 | 14 | 5 | NOV[3]/C303[4] | 5/1 | 0.9 | 280 | 10 | NEG. TONE | 90/30 | -- | 1.5/1 | 351 | -- |
| 75 | 14 | 5 | NOV[3]/C303[4] | 5/1 | 2.9 | 254 | 2.0 | 3D[6] | 90/30 | 3.4 | 1/1 | 351 | -- |
| 76 | 14 | 5 | NOV[3]/C303[4] | 5/1 | 2.9 | 365 | 1000 | 3D[6] | 90/30 | 7.7 | 1.5/1 | 351 | -- |
| 77 | 14 | 5 | NOV[3]/C303[4] | 5/1 | 0.9 | 280 | 10 | NEG. TONE | 90/30 | -- | 1.5/1 | 351 | -- |
| 78 | 14 | 4 | NOV[3]/C303[4] | 5/1 | 2.8 | 365 | 2000 | 3D[6] | 90/30 | 3.75 | 1/1 | 351 | -- |
| 79 | 14 | 4 | NOV[3]/C303[4] | 5/1 | 10.0 | 254 | 150 | 3D[6] | 90/30 | 7.2 | 0.5/1 | 351 | -- |
| 80 | 14 | 4 | NOV[3]/C303[4] | 5/1 | 2.6 | 365 | 750 | 3D[6] | 90/30 | 3.5 | 2/1 | 351 | -- |
| 81 | 14 | 4 | NOV[3]/C303[4] | 5/1 | 9.6 | 365 | 2800 | 3D[6] | 90/30 | 8.0 | 0.5/1 | 351 | -- |

EP 0 232 972 B1

Table 2 (Cont.)

| Example No. | P.G.[1] | WEIGHT % P.G. | AHRS[2] | WEIGHT RATIO NOV/C303 | COATING THICK-NESS μm[7] | EXPOSURE WAVE-LENGTH (nm) | DOSE mJ/cm[2] | MASK | POSTBAKE °C/MINS. | DEVELOP MIN. | DILUTION D/W[13] | D[12] | HEAT TREAT-MENT °C/MIN. |
|---|---|---|---|---|---|---|---|---|---|---|---|---|---|
| 82 | 14 | 4 | NOV[3]/C303[4] | 5/1 | 1.0 | 365 | 14155 | R[5] | 90/30 | 2.2 | 1.5/1 | 351 | -- |
| 83 | 14 | 2 | NOV[3]/C303[4] | 5/1 | 0.9 | 280 | 10-18 | POS. TONE | 90/30 | -- | 1.5/1 | 351 | -- |
| 84 | 15 | 5 | NOV[3]/C303[4] | 5/1 | 1.0 | 254 | 8.4 | | 90/30 | 2.7 | 2/1 | 351 | -- |
| 85 | 15 | 5 | NOV[3]/C303[4] | 5/1 | 2.8 | 254 | 2.0 | 3D[6] | 90/30 | 4.0 | 1/1 | 351 | -- |
| 86 | 15 | 5 | NOV[3]/C303[4] | 5/1 | 2.7 | 365 | 1000 | 3D[6] | 90/30 | 3.7 | 1/1 | 351 | -- |
| 87 | 15 | 4 | NOV[3]/C303[4] | 5/1 | 9.2 | 365 | 2800 | 3D[6] | 90/30 | 9.5 | 0.5/1 | 351 | -- |

[1] Photoacid Generator (See Table 1 for key to Photoacid Generator)
[2] Acid Hardening Resin Systems
[3] NOV is Shipley Co. XP103 cresol-formaldehyde novolak resin.
[4] C303 is Cymel 303
[5] R is regular photomask Example 1.

[6] 3D is attenuated mask according to our EP-A-0.232.973.

[7] (micrometers)

[8] B60 is Beetle 60 urea/formaldehyde resin

[9] C1123 is Cymel 1123 glycoluril resin

[10] PVP is polyvinylphenol

[11] Conventional stencil mask.

[12] D is Shipley Microposit 351 developer

[13] D/W is ratio of volume of developer/volume of water

## Examples 88-102

Table 3 presents the comparative experimental results of photosensitive compositions utilizing photoacid generators and acid-hardening resins following the experimental procedure of Example 1, except as indicated, which did not produce acceptable negative images.

TABLE 3 - COMPARATIVE EXAMPLES

DEEP UV

| Example No. | P.G.[1] | WEIGHT % P.G. | AHRS[2] | WEIGHT RATIO NOV/C303 | COATING THICK-NESS $\mu m$[7] | EXPOSURE WAVE-LENGTH (nm) | DOSE mJ/ $cm^2$ | MASK | POSTBAKE °C/MINS. | DEVELOP MIN. | DILUTION D/W[13] D[12] | HEAT TREAT-MENT °C/MIN. |
|---|---|---|---|---|---|---|---|---|---|---|---|---|
| 88 | 16 | 5 | NOV[3]/C303[4] | 5/1 | 0.96 | 254 | 10 | 3D[6] | 90/30 | 27 | 1/1 | 351 |
| 89 | 17 | 5 | NOV[3]/C303[4] | 5/1 | 0.94 | 254 | 10 | 3D[6] | 90/30 | 6.1 | 1/1 | 351 |
| 90 | 18 | 5 | NOV[3]/C303[4] | 5/1 | 0.98 | 254 | 10 | 3D[6] | 90/30 | 1.9 | 1/1 | 351 |
| 91 | 19 | 5 | NOV[3]/C303[4] | 5/1 | 0.90 | 254 | 10 | 3D[6] | 90/30 | 1.6 | 2/1 | 351 |
| 92 | 20 | 5 | NOV[3]/C303[4] | 5/1 | 0.95 | 254 | 10 | 3D[6] | 90/30 | 3.6 / 2.5 | 2/1 + / 1/1 | 351 |
| 93 | 21 | 5 | NOV[3]/C303[4] | 5/1 | 0.91 | 254 | 10 | 3D[6] | 90/30 | 1.4 | 2/1 | 351 |
| 94 | 22 | 5 | NOV[3]/C303[4] | 5/1 | 0.97 | 254 | 10 | 3D[6] | 90/30 | 1.3 | 2/1 | 351 |
| 95 | 23 | 5 | NOV[3]/C303[4] | 5/1 | 1.0 | 254 | 10 | 3D[6] | 90/30 | 4.5 | 2/1 | 351 |

EP 0 232 972 B1

## TABLE 3 (Cont.)
### DEEP UV

| Example No. | P.G.[1] | WEIGHT % P.G. | AHRS[2] | WEIGHT RATIO NOV/C303 | COATING THICK-NESS μm[7] | EXPOSURE WAVE-LENGTH (nm) | DOSE mJ/ cm[2] | MASK | POSTBAKE °C/MINS. | DEVELOP MIN. D/W[13] | DILUTION D[12] | HEAT TREAT-MENT °C/MIN. |
|---|---|---|---|---|---|---|---|---|---|---|---|---|
| 96 | 24 | 5 | NOV[3]/C303[4] | 5/1 | 1.0 | 254 | 36 | | 90/30 | 2.8 | 2/1 | 351 |
| 97 | 25 | 5 | NOV[3]/C303[4] | 5/1 | 1.0 | 254 | 60 | | 90/30 | 2.4 | 5/1 | 351 |
| 98 | 26 | 5 | NOV[3]/C303[4] | 5/1 | 1.0 | 254 | 60 | | 90/30 | 1.2 | 2/1 | 351 |
| 99 | 27 | 5 | NOV[3]/C303[4] | 5/1 | 0.96 | 254 | 10 | 3D[6] | 90/30 | 1.9 | 2/1 | 351 |
| 100 | 28 | 2 | NOV[3]/C303[4] | 5/1 | 1.3 | 254 | 150 | | 90/30 | 10 | 2/1 | 351 |
| 101 | 28 | 2 | NOV[3]/C303[4] | 5/1 | 1.3 | 365 | 200 | | 90/30 | 10 | 2/1 | 351 |
| 102 | 29 | 4 | NOV[3]/C303[4] | 5/1 | 0.9 | 254 | 60 | | 90/30 | 5 | 2/1 | 351 |

1 to 4, 6, 7, 12 and 13 are as defined in Table 2.

Examples 103-129

Table 4 presents the results of photosensitive compositions employing the photoacid generators and acid-hardening resin systems using x-ray exposure which produced thermally stable, aqueously-devel-

## TABLE 4 - PHOTOSENSITIVE COMPOSITIONS USING X-RAY PHOTOACID GENERATORS

| Example No. | P.G.[1] | WEIGHT % P.G. | AHRS[2] | WEIGHT RATIO NOV/C303 | COATING THICK-NESS $\mu m$[7] | EXPOSURE WAVE-LENGTH (nm) | DOSE mJ/$cm^2$ | A.E[14] | POSTBAKE °C/MINS. | DEVELOP MIN. | DILUTION D/W[13] D[12] |
|---|---|---|---|---|---|---|---|---|---|---|---|
| 103 | 1 | 25 | NOV[3]/C303[4] | 5/1 | 0.99 | 3 | 11 | $3\%O_2$ | 90/30 | 4 | 0.5/1 351 |
| 104 | 1 | 30 | NOV[3]/C303[4] | 5/1 | 1.12 | 3 | 11 | $3\%O_2$ | 90/30 | 6 | 0.5/1 351 |
| 105 | 1 | 25 | NOV[3]/C303[4] | 5/1 | 0.86 | 3 | 11 | AIR | 90/30 | 3.9 | 0.5/1 351 |
| 106 | 1 | 25 | NOV[3]/C303[4] | 5/1 | 0.85 | 3 | 33 | AIR | 90/30 | 5 | 0.5/1 + 1.25 R 351 |
| 107 | 1 | 20 | NOV[3]/C303[4] | 5/1 | 0.94 | 3 | 11 | $3\%O_2$ | 90/30 | 4 | 0.5/1 351 |
| 108 | 1 | 20 | NOV[3]/C303[4] | 5/1 | 0.80 | 3 | 11 | $3\%O_2$ | 90/30 | 2.5 | 0.5/1 351 |
| 109 | 1 | 20 | NOV[3]/C303[4] | 5/1 | 0.80 | 3 | 11 | $3\%O_2$ | 100/30 | 2.2 | 0.5/1 351 |

EP 0 232 972 B1

EP 0 232 972 B1

## Table 4 (Cont.)

| Example No. | P.G.[1] | WEIGHT % P.G. | AHRS[2] | WEIGHT RATIO NOV/C303 | COATING THICK- NESS $\mu m$[7] | EXPOSURE WAVE- LENGTH (nm) | DOSE mJ/ $cm^2$ | A.E[14] | POSTBAKE °C/MINS. | DEVELOP MIN. D/W[13] | DILUTION D[12] |
|---|---|---|---|---|---|---|---|---|---|---|---|
| 110 | 1 | 20 | $NOV^3/C303^4$ | 5/1 | 0.80 | 3 | 11 | $H_2O$ SOAK + AIR | 90/30 | 2.40. 5/1 | 351 |
| 111 | 1 | 20 | $NOV^3/C303^4$ | 5/1 | 0.80 | 3 | 11 | $H_2O$ SOAK + AIR | 100/30 | 2.2 0.5/1 | 351 |
| 112 | 1 | 15 | $NOV^3/C303^4$ | 5/1 | 0.89 | 3 | 11 | $3\%O_2$ | 90/30 | 2.4 0.5/1 | 351 |
| 113 | 1 | 5 | $NOV^3/C303^4$ | 5/1 | 10-1.2 | 3 | | He | 90/30 | -- 1.5/1 | 351 |
| 114 | 1 | 5 | $NOV^3/C303^4$ | 5/1 | 10-1.2 | 3 | 52 | $3\%O_2$ | 90/23 | -- 0.5/1 | 351 |
| 115 | 1 | 2 | $NOV^3/C303^4$ | 5/1 | 10-1.2 | 3 | 131 | $3\%O_2$ | 90°/45 | -- 0.5/1 | 351 |
| 116 | 1 | 2 | $NOV^3/C303^4$ | 5/1 | 10-1.2 | 3 | 131 | AIR | 90/23 | -- 0.5/1 | 351 |

## Table 4 (Cont.)

| Example No. | P.G.[1] | WEIGHT % P.G. | AHRS[2] | WEIGHT RATIO NOV/C303 | COATING THICK-NESS μm[7] | EXPOSURE WAVE-LENGTH (nm) | DOSE mJ/ cm[2] | A.E[14] | POSTBAKE °C/MINS. | DEVELOP MIN. D/W[13] | DILUTION D[12] |
|---|---|---|---|---|---|---|---|---|---|---|---|
| 117 | 1 | 2 | NOV[3]/C303[4] | 5/1 | 10-1.2 | 3 | 131 | H$_2$O SOAK + AIR | 95/23 | --0.5/1-351 | |
| 118 | 2 | 25 | NOV[3]/C303[4] | 5/1 | 1.1 | 3 | 11 | AIR | 90/30 | 0.25 0.5/1 | 351 |
| 119 | 2 | 25 | NOV[3]/C303[4] | 5/1 | 0.96 | 3 | 33 | AIR | 90/30 | 2.25 0.5/1 3.5 R | + 351 |
| 120 | 2 | 2 | NOV[3]/C303[4] | 5/1 | 1.0-1.2 | 3 | | He | 90/30 | -- 1.5/1 | 351 |
| 121 | 6 | 25 | NOV[3]/C303[4] | 5/1 | 0.97 | 3 | 33 | AIR | 90/30 | 1.2 0.5/1 3.9 | 351 + NEAT |
| 122 | 6 | 25 | NOV[3]/C303[4] | 5/1 | 0.95 | 3 | 33 | AIR | 90/30 | 8.75 0.5/1 | 351 |
| 123 | 6 | 2 | NOV[3]/C303[4] | 5/1 | 1.0-1.2 | 3 | 131 | AIR | 95/25 | 8.75 1.5/1 | 351 |

EP 0 232 972 B1

Table 4 (Cont.)

| Example No. | P.G.[1] | WEIGHT % P.G.[1] | AHRS[2] | WEIGHT RATIO NOV/C303 | COATING EXPOSURE THICK-NESS μm[7] | WAVE-LENGTH (nm) | DOSE mJ/cm[2] | A.E.[14] | POSTBAKE °C/MINS. | DEVELOP MIN. DILUTION | D/W[13] | D[12] |
|---|---|---|---|---|---|---|---|---|---|---|---|---|
| 124 | 9 | 2 | NOV[3]/C303[4] | 5/1 | 1.0-1.2 | 3 | 3 | He | 90/30 | | 1.5/1 | 351 |
| 125 | 10 | 2 | NOV[3]/C303[4] | 5/1 | 1.0-1.2 | 3 | 3 | He | 90/30 | | 0.5/1 | 351 |
| 126 | 12 | 25 | NOV[3]/C303[4] | 5/1 | 0.94 | 3 | 11 | 3%$O_2$ | 90/30 | 3 | 0.5/1 | 351 |
| 127 | 12 | 2 | NOV[3]/C303[4] | 5/1 | 1.0-1.2 | 3 | 11 | He | 90/30 | | 1.5/ | 351 |
| 128 | 24 | 25 | NOV[3]/C303[4] | 5/1 | 0.94 | 3 | 33 | AIR | 90/30 | 0.75 | 0.5/1 | 351 |
| 129 | 11 | 2 | NOV[3]/C303[4] | 5/1 | 1.0-1.2 | 3 | 33 | He | 90/30 | -- | 1.5/1 | 351 |

1 to 4, 7, 12 and 13 are as defined in Table 2
14 is Ambient Exposure

Example 130

Table 5 presents the comparative experimental results of a photosensitive composition utilizing x-ray photoacid generator and acid-hardening resin following the experimental procedure of Example 3, except as indicated, which did not produce acceptable negative images.

TABLE 5 – COMPARATIVE EXAMPLE X-RAY

| Example No. | WEIGHT % P.G.[1] & P.G. AHRS[2] | | WEIGHT RATIO NOV/C303 | COATING THICKNESS $\mu m$[7] | EXPOSURE WAVE-LENGTH (nm) | DOSE $mJ/cm^2$ A.E[14] | POSTBAKE °C/MINS. | DEVELOP MIN. DILUTION D/W[13] D[12] | | |
|---|---|---|---|---|---|---|---|---|---|---|
| | | NOV[3]/C303[4] | | | | | | | | |
| 26 | 25 | 130 | 5/1 | .87 | 3 | 11 3%$O_2$ | 90/30 | .25 | 1.5/1 | 351 |

1 to 4, 7, 12 and 13 are as defined in Table 2

14 is as defined in Table 4.

The terms "Kelthane", "Dursban", "Cellosolve", "Propasol", "Cymel", "Microposit", "Micralyn" and "Beetle" are trade marks which may or may not be registered in one or more of the designated states.

**Claims**

1. A negative-acting, aqueous base developable, photoresist composition which comprises:
   (a) acid-hardening resin system comprising (I) aminoplast resin and reactive hydrogen-containing compound, or (II) phenoplast resin and latent formaldehyde-generating compound; and
   (b) halogenated, organic, photoacid generating compound which selectively absorbs actinic radiation having a wavelength in the range of about 299 nanometers or less and which is selected from:
   1,1-bis [p-chlorophenyl]-2,2,2-trichloroethane;
   1,1-bis [p-methoxyphenyl]-2,2,2-trichloroethane;
   1,2,5,6,9,10-hexabromocyclododecane;
   1,10-dibromodecane;
   1,1-bis [p-chlorophenyl]-2,2-dichloroethane;
   4,4'-dichloro-2-(trichloromethyl) benzhydrol or 1,1-bis [p-chlorophenyl]-2,2,2-trichloroethanol;
   hexachlorodimethyl sulfone;
   2-chloro-6- (trichloromethyl) pyridine;
   0,0-diethyl-0- (3,5,6-trichloro-2-pyridyl) phosphorothioate;
   1,2,3,4,5,6-hexachlorocyclohexane;
   N (1,1-bis [p-chlorophenyl]-2,2,2-trichloroethyl) acetamide;
   tris [2,3-dibromopropyl] isocyanurate;
   tris [2,3-dichloropropyl] phosphate;
   1,1-bis [p-chlorophenyl]-2,2-dichloroethylene;
   and their isomers and homologs.

2. A composition as claimed in claim 1, in which component (b) selectively absorbs actinic radiation having a wavelength in the range of about 210 to about 299 nanometers.

3. A composition as claimed in claim 2, in which component (b) is present in the composition at a concentration of from about 0.1 to 10, preferably from about 0.1 to 5, weight percent when the exposing radiation dosage is at least 10 mJ/cm$^2$.

4. A composition as claimed in claim 1, in which component (b) selectively absorbs actinic radiation in the x-ray region.

5. A process for preparing a negative, thermally stable image on a substrate surface, which comprises:
   (a) depositing a photosensitive solution on a substrate surface, the photosensitive solution comprising:
   (i) acid-hardening resin system comprising (I) aminoplast resin and reactive hydrogen-containing compound, or (II) phenoplast resin and latent formaldehyde-generating compound; and
   (ii) halogenated, organic, photoacid generating compound which selectively absorbs actinic radiation having a wavelength in the range of about 299 nanometers or less and which is selected from:
   1,1-bis [p-chlorophenyl]-2,2,2-trichloroethane;
   1,1-bis [p-methoxyphenyl]-2,2,2-trichloroethane;
   1,2,5,6,9,10-hexabromocyclododecane;
   1,10-dibromodecane;
   1,1-bis [p-chlorophenyl]-2,2-dichloroethane;
   4,4'-dichloro-2-(trichloromethyl) benzhydrol or 1,1-bis [p-chlorophenyl]-2,2,2-trichloroethanol;
   hexachlorodimethyl sulfone;
   2-chloro-6- (trichloromethyl) pyridine;
   0,0-diethyl-0- (3,5,6-trichloro-2-pyridyl) phosphorothioate;
   1,2,3,4,5,6-hexachlorocyclohexane;
   N (1,1-bis [p-chlorophenyl]-2,2,2-trichloroethyl) acetamide;
   tris [2,3-dibromopropyl] isocyanurate;
   tris [2,3-dichloropropyl] phosphate;
   1,1-bis [p-chlorophenyl]-2,2-dichloroethylene;
   and their isomers and homologs;
   (b) heating the deposited photosensitive solution to form a coating;

(c) exposing at least one portion of the coating to a source of actinic radiation having a wavelength in the range of about 299 nanometers or less;

(d) developing unexposed portion(s) of the coating with an aqueous base developer; and

(e) heating the exposed portion(s) of the coating to an elevated temperature to form a negative image that is thermally stable to temperatures in excess of 200°C.

6. A process as claimed in claim 5, in which the source of actinic radiation has a wavelength in the range of about 210 to about 299 nanometers.

7. A process as claimed in claim 5, in which the source of actinic radiation is a source of x-radiation and the photosensitive solution contains at least 10 weight percent of the photoacid generating compound.

8. A process as claimed in claim 7, in which the image produced has a resolution of from about 0.2 to 1 micrometer.

9. A process as claimed in any of claims 5 to 8, in which in step (b) the deposited photosensitive solution is heated at about 90°C for about 30 minutes.

**Patentansprüche**

1. Negativ arbeitende, entwickelbare Fotolackzusammensetzung auf wäßriger Basis, dadurch gekennzeichnet, daß sie enthält:

(a) ein sauer härtendes Harzsystem enthaltend (I) Aminoplastharz und einen reaktiven Wasserstoff enthaltende Verbindung oder (II) Phenoplastharz und latenten Formaldehyd erzeugende Verbindung, und

(b) halogenierte organische Photosäure erzeugende Verbindung, die selektiv aktinische Strahlung mit einer Wellenlänge im Bereich von etwa 299 nm oder weniger absorbiert und gewählt ist aus:

1,1-bis-[p-Chlorphenyl]-2,2,2-trichlorethan;

1,1-bis-[p-Methoxyphenyl]-2,2,2-trichlorethan;

1,2,5,6,9,10-Hexabromcyclododecan;

1,10-Dibromdecan;

1,1-bis[p-Chlorphenyl]-2,2-dichlorethan;

4,4'-Dichlor-2-(trichlormethyl)-benzhydrol oder 1,1-bis-[p-Chlorphenyl]-2,2,2-trichlorethanol;

Hexachlordimethylsulfon;

2-Chlor-6-(trichlormethyl)-pyridin;

0,0-Diethyl-0-(3,5,6-trichlor-2-pyridyl)-phosphorthioat;

1,2,3,4,5,6-Hexachlorcyclohexan;

N-(1,1-bis-[p-chlorphenyl]-2,2,2-trichlorethyl)-acetamid;

tris-[2,3-Dibrompropyl]-isocyanurat;

tris-[2,3-Dichlorpropyl]-phosphat;

1,1-bis-[p-Chlorphenyl]-2,2-dichlorethylen

und ihren Isomeren und Homologen.

2. Zusammensetzung nach Anspruch 1, dadurch gekennzeichnet, daß die Komponente (b) selektiv aktinische Strahlung mit einer Wellenlänge im Bereich von etwa 210 bis etwa 299 nm absorbiert.

3. Zusammensetzung nach Anspruch 2, dadurch gekennzeichnet, daß die Komponente (b) in der Zusammensetzung in einer Konzentration von etwa 0,1 bis 10, vorzugsweise etwa 0,1 bis 5 Gew.-% vorliegt, wenn die belichtende Strahlungsdosis wenigstens 10 mJ/cm$^2$ beträgt.

4. Zusammensetzung nach Anspruch 1, dadurch gekennzeichnet, daß die Komponente (b) selektiv aktinische Strahlung im Röntgenstrahlenbereich absorbiert.

5. Verfahren zur Herstellung eines negativen thermisch stabilen Bildes auf einer Substratoberfläche, dadurch gekennzeichnet, daß man

(a) eine photoempfindliche Lösung auf einer Substratoberfläche abscheidet, wobei die photoempfindliche Lösung enthält:

(i) ein sauer härtendes Harzsystem, das (I) Aminoplastharz und eine reaktiven Wasserstoff enthaltende Verbindung enthält oder (II) Phenoplastharz und eine latente Formaldehyd erzeugende Verbindung und

(ii) halogenierte organische Photosäure erzeugende Verbindung, die selektiv aktinische Strahlung mit einer Wellenlänge im Bereich von etwa 299 nm oder weniger adsorbiert und die gewählt ist aus:

1,1-bis-[p-Chlorphenyl]-2,2,2-trichlorethan;

1,1-bis-[p-Methoxyphenyl]-2,2,2-trichlorethan;

1,2,5,6,9,10-Hexabromcyclododecan;

1,10-Dibromdecan;

1,1-bis[p-Chlorphenyl]-2,2-dichlorethan;

4,4'-Dichlor-2-(trichlormethyl)-benzhydrol oder 1,1-bis-[p-Chlorphenyl]-2,2,2-trichlorethanol;

Hexachlordimethylsulfon;

2-Chlor-6-(trichlormethyl)-pyridin;

0,0-Diethyl-0-(3,5,6-trichlor-2-pyridyl)-phosphorthioat;

1,2,3,4,5,6-Hexachlorcyclohexan;

N-(1,1-bis-[p-chlorphenyl]-2,2,2-trichlorethyl)-acetamid;

tris-[2,3-Dibrompropyl]-isocyanurat;

tris-[2,3-Dichlorpropyl]-phosphat;

1,1-bis-[p-Chlorphenyl]-2,2-dichlorethylen

und ihren Isomeren und Homologen;

(b) Erhitzen der abgeschiedenen photoempfindlichen Lösung zur Bildung des Überzugs;

(c) Belichten wenigstens eines Teils des Überzugs mit einer Quelle von aktinischer Strahlung mit einer Wellenlänge im Bereich von etwa 299 nm oder weniger

(d) Entwickeln des nicht belichteten Teils oder der nicht belichteten Teile des Überzuges mit einem Entwickler auf wäßriger Basis und

(e) Erhitzen des belichteten Teils oder der belichteten Teile des Überzugs auf eine erhöhte Temperatur zur Bildung eines Negativbildes, das thermisch gegenüber Temperaturen über 200 °C stabil ist.

6. Verfahren nach Anspruch 5, dadurch gekennzeichnet, daß die Quelle der aktinischen Strahlung eine Wellenlänge im Bereich von etwa 210 bis etwa 299 nm hat.

7. Verfahren nach Anspruch 5, dadurch gekennzeichnet, daß die Quelle für aktinische Strahlung eine Quelle von Röntgenstrahlung ist und die photoempfindliche Lösung wenigstens 10 Gew.-% der Photosäure erzeugenden Verbindung enthält.

8. Verfahren nach Anspruch 7, dadurch gekennzeichnet, daß das erzeugte Bild eine Auflösung von etwa 0,2 bis 1 $\mu$m hat.

9. Verfahren nach einem der Ansprüche 5 bis 8, dadurch gekennzeichnet, daß in Stufe (b) die abgeschiedene photoempfindliche Lösung etwa 30 Minuten lang auf etwa 90 °C erhitzt wird.

**Revendications**

1. Une composition photoréserve négative, développable par une base aqueuse , qui comprend :

(a) un système de résine durcissable par l'acide comprenant ( I) une résine aminoplaste et un composé contenant de l'hydrogène réactif , ou (II) une résine phénoplaste et un composé engendrant du formaldéhyde latent ; et

(b) un composé organique halogéné engendrant un acide photoréactif ou photosensible qui absorbe sélectivement un rayonnement actinique ayant une longueur d'onde dans la gamme d'environ 299 nanomètres ou moins et qui est choisi parmi :

1,1-bis[p-chlorophényl]-2,2,2-trichloroéthane;

1,1-bis[p-méthoxyphényl]-2,2,2-trichloroéthane;

1,2,5,6,9,10-hexabromocyclododécane ;

1,10-dibromodécane;

1,1-bis[p-chlorophényl]-2,2-dichloroéthane;

4,4'-dichloro-2-(trichlorométhyl)benzhydrol ou 1,1-bis[p-chlorophényl]-2,2,2-trichloroéthanol;

32

hexachlorodiméthyl sulfone ;

2-chloro-6-(trichlorométhyl) pyridine;

0,0-diéthyl-0-(3,5,6-trichloro-2-pyridyl) phosphorothioate

1,2,3,4,5,6-hexachlorocyclohexane;

N(1,1-bis[p-chlorophényl]-2,2,2-trichloroéthyl)acétamide;

tris [2,3-dibromopropyl] isocyanurate ;

tris [2,3-dichloropropyl ] phosphate ;

1,1-bis [p-chlorophényl)-2,2-dichloroéthylène;

et leurs isomères et homologues .

2. Une composition telle que revendiquée dans la revendication 1 , dans laquelle le composant ( b) absorbe sélectivement un rayonnement actinique ayant une longueur d'onde dans la gamme d'environ 210 à environ 299 nanomètres.

3. Une composition telle que revendiquée dans la revendication 2 , dans laquelle le composant (b) est présent dans la composition à une concentration d'environ 0,1 à 10 , de préférence d'environ 0,1 à 5 , pourcent en poids lorsque le dosage du rayonnement d'exposition est d'au moins 10 mJ/cm$^2$.

4. Une composition telle que revendiquée dans la revendication 1, dans laquelle le composant (b) absorbe sélectivement un rayonnement actinique dans la région des rayons X.

5. Un procédé pour préparer une image négative, thermiquement stable, sur une surface constituant un substrat, qui comprend :

(a) le dépôt d'une solution photosensible sur une surface constituant un substrat , la solution photosensible comprenant :

(i) un système de résine durcissable par l'acide comprenant (I), une résine aminoplaste et un composant contenant de l'hydrogène réactif , ou ( II ) une résine phénoplaste et un composé engendrant du formaldéhyde latent ; et

(ii) un composé organique halogéné engendrant un acide photoréactif ou photosensible qui absorbe sélectivement un rayonnement actinique ayant une longueur d'onde dans la gamme d'environ 299 nanomètres ou moins et qui est choisi parmi :

1,1-bis[p-chlorophényl]-2,2,2-trichloroéthane;

1,1-bis[p-méthoxyphényl]-2,2,2-trichloroéthane;

1,2,5,6,9,10-hexabromocyclododécane ;

1,10-dibromodécane;

1,1-bis[p-chlorophényl]-2,2-dichloroéthane;

4,4'-dichloro-2-(trichlorométhyl)benzhydrol ou 1,1-bis[p-chlorophényl]-2,2,2-trichloroéthanol;

hexachlorodiméthyl sulfone ;

2-chloro-6-(trichlorométhyl) pyridine;

0,0-diéthyl-0-(3,5,6-trichloro-2-pyridyl) phosphorothioate

1,2,3,4,5,6-hexachlorocyclohexane;

N(1,1-bis[p-chlorophényl]-2,2,2-trichloroéthyl)acétamide;

tris [2,3-dibromopropyl] isocyanurate ;

tris [2,3-dichloropropyl ] phosphate ;

1,1-bis [p-chlorophényl)-2,2-dichloroéthylène;

et leurs isomères et homologues ;

(b) le chauffage de la solution photosensible déposée, afin de former un revêtement ;

(c) l'exposition d'au moins une portion du revêtement à une source de rayonnement actinique ayant une longueur d'onde dans la gamme d'environ 299 nanomètres ou moins ;

(d) le développement de la ou des portions non exposées du revêtement au moyen d'un développorteur basique aqueux ; et

(e) le chauffage de la portion ou des portions exposées du revêtement à une température élevée pour former une image négative qui est thermiquement stable aux températures dépassant 200° C.

6. Un procédé comme revendiqué dans la revendication 5, dans lequel la source de rayonnement actinique a une longueur d'onde dans la gamme d'environ 210 à environ 299 nanomètres.

**7.** Un procédé comme revendiqué dans la revendication 5, dans lequel la source de rayonnement actinique est une source de rayonnement X et la solution photosensible contient au moins 10% en poids du composé engendrant l'acide photoréactif ou photosensible .

**8.** Un procédé tel que revendiqué dans la revendication 7, dans lequel l'image produite a une résolution d'au moins environ 0,2 à 1 micromètre .

**9.** Un procédé tel que revendiqué dans l'une quelconque des revendications 5 à 8 , dans lequel , dans la phase (b) , la solution photosensible déposée est chauffée à environ 90°C pendant environ 30 minutes.